(19) Europäisches Patentamt
European Patent Office
Office européen des brevets

(11) **EP 4 568 457 A1**

(12) **EUROPEAN PATENT APPLICATION**
published in accordance with Art. 153(4) EPC

(43) Date of publication:
**11.06.2025  Bulletin 2025/24**

(21) Application number: **23913940.5**

(22) Date of filing: **03.01.2023**

(51) International Patent Classification (IPC):
***H10K 30/10*** *(2023.01)*

(52) Cooperative Patent Classification (CPC):
**H10K 30/10**

(86) International application number:
**PCT/CN2023/070213**

(87) International publication number:
**WO 2024/145780 (11.07.2024 Gazette 2024/28)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Contemporary Amperex Technology (Hong Kong) Limited**
**Central, Hong Kong (HK)**

(72) Inventors:
• **CHEN, Changsong**
**Ningde, Fujian 352100 (CN)**
• **CHEN, Guodong**
**Ningde, Fujian 352100 (CN)**
• **TU, Bao**
**Ningde, Fujian 352100 (CN)**
• **LIU, Xiao**
**Ningde, Fujian 352100 (CN)**
• **GUO, Wenming**
**Ningde, Fujian 352100 (CN)**
• **GUO, Yongsheng**
**Ningde, Fujian 352100 (CN)**
• **OUYANG, Chuying**
**Ningde, Fujian 352100 (CN)**

(74) Representative: **Kraus & Lederer PartGmbB**
**Thomas-Wimmer-Ring 15**
**80539 München (DE)**

(54) **PEROVSKITE SOLAR CELL, MANUFACTURING METHOD THEREFOR AND ELECTRICAL APPARATUS**

(57)  This application discloses a perovskite solar cell and a preparation method thereof, and an electrical apparatus. The perovskite solar cell includes a first electrode, a first charge transport layer, a perovskite absorption layer, a second charge transport layer, and a second electrode. The first charge transport layer is arranged on a side of the first electrode; the perovskite absorption layer is arranged on a side of the first charge transport layer away from the first electrode; the second charge transport layer is arranged on a side of the perovskite absorption layer away from the first charge transport layer; and the second electrode is arranged on a side of the second charge transport layer away from the perovskite absorption layer; where the perovskite absorption layer, the second charge transport layer, and the second electrode meet the following relations: $d = k\lambda/2n_1$ and $n_1^2 = an_2 \times n_0$, where d represents a thickness of the second charge transport layer in nm; k is a positive integer; $\lambda$ represents wavelength of a main band of light absorbed by the perovskite absorption layer; $n_0$ is a refractive index of the perovskite absorption layer; $n_1$ is a refractive index of the second charge transport layer; $n_2$ is a refractive index of the second electrode; and a is a correction factor with a value of 0.5 to 1.5.

FIG. 2

**Description**

## TECHNICAL FIELD

This application relates to the field of solar cells, and specifically to a perovskite solar cell and a preparation method thereof, and an electrical apparatus.

## BACKGROUND

Perovskite solar cells have attracted wide attention due to their excellent photoelectric properties, for example, adjustable band gap, high light absorption coefficient, long carrier lifetime and diffusion length, high defect tolerance, and low-cost low-temperature liquid phase preparation method.

However, part of light incident into a cell device undergoes energy deposition in a perovskite absorption layer, while the remaining part penetrates through the layer, causing light loss.

## SUMMARY

In view of the technical problem existing in the background, this application provides a perovskite solar cell, aiming to alleviate the problem of light loss caused by part of incident light penetrating a perovskite absorption layer during use of existing perovskite solar cells.

To achieve the foregoing objective, a first aspect of this application provides a perovskite solar cell, including:

a first electrode;

a first charge transport layer, where the first charge transport layer is arranged on a side of the first electrode;

a perovskite absorption layer, where the perovskite absorption layer is arranged on a side of the first charge transport layer away from the first electrode;

a second charge transport layer, where the second charge transport layer is arranged on a side of the perovskite absorption layer away from the first charge transport layer; and

a second electrode, where the second electrode is arranged on a side of the second charge transport layer away from the perovskite absorption layer;

where the perovskite absorption layer, the second charge transport layer, and the second electrode meet the following relations:

$d = k\lambda/2n_1$ and $n_1^2 = an_2 \times n_0$,

where d represents a thickness of the second charge transport layer in nm;

k is a positive integer;

$\lambda$ represents a wavelength of a main band of light absorbed by the perovskite absorption layer in nm;

$n_0$ is a refractive index of the perovskite absorption layer;

$n_1$ is a refractive index of the second charge transport layer;

$n_2$ is a refractive index of the second electrode; and

a is a correction factor with a value of 0.5 to 1.5.

Compared to the prior art, this application at least includes the following beneficial effects: In the perovskite solar cell of this application, the perovskite absorption layer, the second charge transport layer, and the second electrode meet both of the following relations: $d = k\lambda/2n_1$ and $n_1^2 = an_2 \times n_0$, so that the second charge transport layer in the perovskite cell has excellent enhanced reflection effect, and thus part of light passing through the perovskite absorption layer can be reflected back to the perovskite absorption layer through the second charge transport layer, increasing a quantity of carriers in the perovskite absorption layer, and increasing a cell current. In this way, the perovskite solar cell of this application has a higher power conversion efficiency.

In some embodiments of this application, the refractive index $n_0$ of the perovskite absorption layer ranges from 0.5 to 3.

In some embodiments of this application, the refractive index $n_1$ of the second charge transport layer ranges from 0.5 to 3.

In some embodiments of this application, the refractive index $n_2$ of the second electrode ranges from 0.5 to 3.

In some embodiments of this application, the second charge transport layer includes a radioactive material. In this way, the refractive index of the second charge transport layer can be adjusted; and the radioactive material has radioactivity, and high-energy radiation particles therein can self-stimulate to generate carriers, increasing a quantity of carriers, thereby increasing the cell current.

In some embodiments of this application, based on a total mass of the second charge transport layer, a percentage of the radioactive material in the second charge transport layer does not exceed 30wt%, and optionally ranges from 3wt% to 15wt%. In this way, the carriers and the cell current can be increased.

In some embodiments of this application, the radioactive material includes at least one of $\alpha$-type radiation source material and $\beta$-type radiation source material. In this way, the carriers and the cell current can be increased.

In some embodiments of this application, the $\alpha$-type radiation source material includes at least one of $^{210}$Po and compounds thereof, $^{228}$Th and compounds thereof, $^{235}$U and compounds thereof, $^{238}$Pu and compounds thereof, $^{241}$Am and compounds thereof, $^{242}$Cm and compounds thereof, and $^{244}$Cm and compounds thereof. In this way, the carriers and the cell current can be increased.

In some embodiments of this application, the $\beta$-type radiation source material includes at least one of $(C_4H_3{}^3H_5{}^-)$n, $^3H_2$, $Ti^3H_4$, $^{14}$C and compounds thereof, $^{35}$S and compounds thereof, $^{63}$Ni and compounds thereof, $^{90}$Sr and compounds thereof, $^{99}$Tc and compounds thereof, $^{106}$Ru and compounds, $^{137}$Cs and compounds thereof, $^{144}$Ce and compounds thereof, $^{147}$Pm and compounds thereof, $^{151}$Sm and compounds thereof, and $^{226}$Ra and compounds thereof. In this way, the carriers and the cell current can be increased.

In some embodiments of this application, the second charge transport layer is an electron transport layer, and the first charge transport layer is a hole transport layer, where an electron transport material in the electron transport layer includes at least one of imide compounds, quinone compounds, fullerenes and derivatives thereof, metal oxides, silicon oxides, strontium titanate, calcium titanate, lithium fluoride, and calcium fluoride, and a metal element in the metal oxides includes at least one of Mg, Cd, Zn, In, Pb, W, Sb, Bi, Hg, Ti, Ag, Mn, Fe, V, Sn, Zr, Sr, Ga, and Cr.

In some embodiments of this application, the second charge transport layer is a hole transport layer, and the first charge transport layer is an electron transport layer, where a hole transport material in the hole transport layer includes 2,2',7,7'-tetra(N,N-para-methoxyaniline)-9,9'-spirobifluorene, methoxytriphenylamine-fluoroformamidine, poly[bis(4-phenyl)(2,4,6-trimethylphenyl)amine], poly(3,4-ethylenedioxythiophene), polystyrene sulfonic acid, poly(3-hexylthiophene), triphenylamine with triptycene as the core, 3,4-ethylenedioxythiophene-methoxytriphenylamine, N-(4-anilino) carbazole-spirobifluorene, polythiophene, phosphate-based monomers, carbazole-based monomers, sulfonic acid-based monomers, triphenylamine-based monomers, aromatic monomers, metal oxides, and cuprous thiocyanate, and a metal element in the metal oxides includes at least one of Ni, Mo, and Cu.

In some embodiments of this application, the perovskite solar cell further includes a buffer layer, where the buffer layer is arranged between the second charge transport layer and the perovskite absorption layer. In this way, the damage to the perovskite absorption layer caused by high-energy radiation particles radiated by the radioactive material in the second charge transport layer can be reduced.

In some embodiments of this application, a valence band maximum and a conduction band minimum of a material of the buffer layer is at least 2.5 eV apart. In this way, the buffer layer may absorb high-energy particles radiated by the radioactive material in the second charge transport layer, thereby reducing the damage to the perovskite absorption layer.

In some embodiments of this application, the material of the buffer layer includes at least one of an inorganic wide bandgap semiconductor material and an organic wide bandgap semiconductor material. In this way, the damage to the perovskite absorption layer can be reduced.

In some embodiments of this application, the inorganic wide bandgap semiconductor material includes at least one of an II-VI group compound semiconductor, an III-V group compound semiconductor, transition metal oxides, transition metal halides, and a silicon-based wide bandgap semiconductor. In this way, the damage to the perovskite absorption layer can be reduced.

In some embodiments of this application, the organic wide bandgap semiconductor material includes at least one of C60, PC61BM ((6,6)-phenyl-C61-butyric acid methyl ester), PC71BM ((6,6)-phenyl-C71-butyric acid methyl ester), P3HT (poly(3-hexylthiophene)), PTAA (poly[bis(4-phenyl)(2,4,6-trimethylphenyl)amine]), and PEDOT:PSS (poly(3,4-ethylenedioxythiophene)-poly(styrenesulfonate)). In this way, the damage to the perovskite absorption layer can be reduced.

In some embodiments of this application, a refractive index $n_3$ of the buffer layer, the refractive index $n_1$ of the second charge transport layer, and the refractive index $n_2$ of the second electrode meet the following relation: $n_1{}^2 = bn_2 \times n_3$, where b is a correction factor with a value of 0.5 to 1.5. In this way, the transmittance of incident light can be improved, and the power conversion efficiency of the cell can be improved.

In some embodiments of this application, the refractive index $n_3$ of the buffer layer ranges from 0.5 to 3. In this way, the transmittance of incident light can be improved, and the power conversion efficiency of the cell can be improved.

In some embodiments of this application, a thickness of the buffer layer does not exceed 10 nm. In this way, the transmittance of incident light can be improved, and the power conversion efficiency of the cell can be improved.

A second aspect of this application provides a preparation method of perovskite solar cell, including:

forming a first charge transport layer on a side of a first electrode;
forming a perovskite absorption layer on a side of the first charge transport layer away from the first electrode;

forming a second charge transport layer on a side of the perovskite absorption layer away from the first charge transport layer; and

forming a second electrode on a side of the second charge transport layer away from the perovskite absorption layer;

where the perovskite absorption layer, the second charge transport layer, and the second electrode meet the following relation:

$d = k\lambda/2n_1$, and $n_1^2 = an_2 \times n_0$,

where d represents a thickness of the second charge transport layer in nm;

k is a positive integer;

$\lambda$ represents a wavelength of a main band of light absorbed by the perovskite absorption layer in nm;

$n_0$ is a refractive index of the perovskite absorption layer;

$n_1$ is a refractive index of the second charge transport layer;

$n_2$ is a refractive index of the second electrode; and

a is a correction factor with a value of 0.5 to 1.5.

In this way, using the method of this application, the above-described perovskite solar cell with excellent power conversion efficiency can be prepared.

In some embodiments of this application, the preparation method of perovskite solar cell further includes: forming a buffer layer between the second charge transport layer and the perovskite absorption layer. In this way, the damage to the perovskite absorption layer caused by high-energy radiation particles radiated by the radioactive material in the second charge transport layer can be reduced.

A third aspect of this application provides an electrical apparatus, including the perovskite solar cell according to the first aspect or a perovskite solar cell prepared by the method according to the second aspect, where the perovskite solar cell is configured to provide electrical energy.

The foregoing description is merely an overview of the technical solution of this application. To more clearly understand the technical means in this application so that they can be implemented according to the content of the specification, and to make the above and other objectives, features, and advantages of this application more obvious and easier to understand, the following describes specific embodiments of this application.

**BRIEF DESCRIPTION OF DRAWINGS**

Persons of ordinary skill in the art can clearly understand various other advantages and benefits by reading the detailed description of the preferred embodiments below. The accompanying drawings are merely intended to illustrate the preferred embodiments and are not intended to limit this application. In addition, in all the accompanying drawings, same components are denoted by same reference signs. In the accompanying drawings:

FIG. 1 is a schematic structural diagram of a perovskite solar cell in the prior art.

FIG. 2 is a schematic structural diagram of a perovskite solar cell according to an embodiment of this application.

FIG. 3 is a schematic structural diagram of a perovskite solar cell according to another embodiment of this application.

FIG. 4 is a diagram showing a working principle of a perovskite solar cell according to another embodiment of this application.

Description of reference signs:

1000: perovskite solar cell; 100: first electrode; 200: first charge transport layer; 300: perovskite absorption layer; 400: second charge transport layer; 500: second electrode; and 600: buffer layer.

**DESCRIPTION OF EMBODIMENTS**

The following describes in detail the embodiments of technical solutions of this application in detail. The following embodiments are merely intended for a clearer description of the technical solutions of this application and therefore are used as just examples which do not constitute any limitations on the protection scope of this application.

In this specification, reference to "embodiment" means that specific features, structures or characteristics described with reference to the embodiment may be incorporated in at least one embodiment of this application. The word "embodiment" appearing in various places in the specification does not necessarily refer to the same embodiment or an independent or alternative embodiment that is exclusive of other embodiments. Persons skilled in the art explicitly and implicitly understand that the embodiments described herein may be combined with other embodiments.

For brevity, this specification specifically discloses only some numerical ranges. However, any lower limit may be combined with any upper limit to form an unspecified range, and any lower limit may be combined with another lower limit to form an unspecified range, and likewise, any upper limit may be combined with any other upper limit to form an unspecified range. In addition, each individually disclosed point or individual single numerical value may itself be a lower limit or an upper limit which can be combined with any other point or individual numerical value or combined with another lower limit or upper limit to form a range not expressly recorded.

In the description of the embodiments of this application, the term "and/or" is only an associative relationship for describing associated objects, indicating that three relationships may be present. For example, A and/or B may indicate the following three cases: presence of only A, presence of both A and B, and presence of only B. In addition, a character "/" in this specification generally indicates an "or" relationship between contextually associated objects.

Unless otherwise defined, all technical and scientific terms used herein shall have the same meanings as commonly understood by persons skilled in the art to which this application relates. The terms used herein are intended to merely describe the specific embodiments rather than to limit this application. The terms "include/comprise" and "have" and any other variations thereof in the specification, claims, and brief description of drawings of this application are intended to cover non-exclusive inclusions.

Perovskite solar cells have attracted wide attention due to their excellent photoelectric properties, for example, adjustable band gap, high light absorption coefficient, long carrier lifetime and diffusion length, high defect tolerance, and low-cost low-temperature liquid phase preparation method.

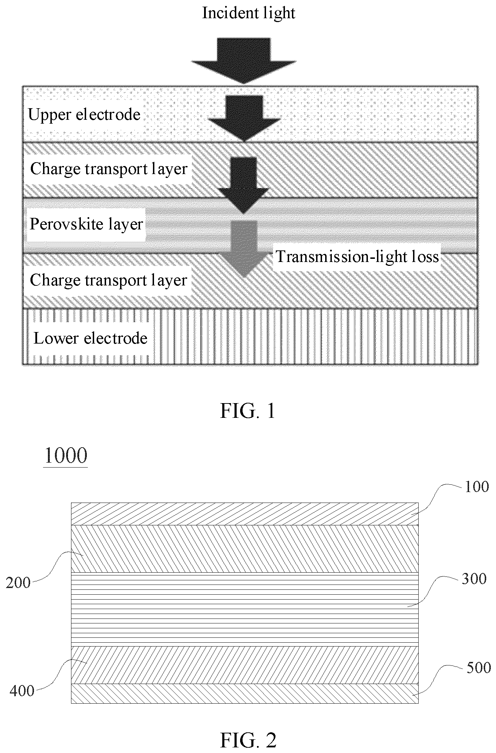

As shown in FIG. 1, an existing perovskite solar cell includes an upper electrode, a charge transport layer, a perovskite layer, a charge transport layer, and a lower electrode. Incident light enters from above the upper electrode, part of the light undergoes energy deposition in the perovskite absorption layer, and the remaining part penetrates through the layer, causing light loss, which reduces the power conversion efficiency of the cell.

Therefore, a first aspect of this application discloses a perovskite solar cell. Referring to FIG. 2, the perovskite solar cell 1000 include a first electrode 100, a first charge transport layer 200, a perovskite absorption layer 300, a second charge transport layer 400, and a second electrode 500. The first charge transport layer 200 is arranged on a side of the first electrode 100; the perovskite absorption layer 300 is arranged on a side of the first charge transport layer 200 away from the first electrode 100; the second charge transport layer 400 is arranged on a side of the perovskite absorption layer 300 away from the first charge transport layer 200; and the second electrode 500 is arranged on a side of the second charge transport layer 400 away from the perovskite absorption layer 300; where the perovskite absorption layer 300, the second charge transport layer 400, and the second electrode 500 meet the following relations: $d=k\lambda/2n_1$ and $n_1^2=an_2\times n_0$, where d represents a thickness of the second charge transport layer 400 in nm; k is a positive integer; $\lambda$ represents wavelength of a main band of light absorbed by the perovskite absorption layer 300 in nm; $n_0$ is a refractive index of the perovskite absorption layer 300; $n_1$ is a refractive index of the second charge transport layer 400; $n_2$ is a refractive index of the second electrode 500; and a is a correction factor with a value of 0.5 to 1.5, for example, 0.5, 0.6, 0.7, 0.8, 0.9, 1.0, 1.1, 1.2, 1.3, 1.4, and 1.5.

Through extensive research, the inventors found that in the perovskite solar cell of this application, the perovskite absorption layer, the second charge transport layer, and the second electrode meet both of the following relations: $d=k\lambda/2n_1$ and $n_1^2=an_2\times n_0$, so that the second charge transport layer in the perovskite cell has excellent enhanced reflection effect, and thus part of light passing through the perovskite absorption layer can be reflected back to the perovskite absorption layer through the second charge transport layer, increasing a quantity of carriers in the perovskite absorption layer, and increasing a cell current. In this way, the perovskite solar cell of this application has a higher power conversion efficiency.

According to some examples, a method for testing "a wavelength $\lambda$ of the main band of light absorbed by the perovskite absorption layer 300" includes: at room temperature, test a perovskite solid film sample using an ultraviolet-visible spectrophotometer (Shimadzu UV-Vis 3200), obtaining an absorption spectrum in a visible light band, and taking a wavelength corresponding to a band with a maximum absorption value in the absorption spectrum as the wavelength $\lambda$ of the main band of light aborted; and methods for testing "the refractive index $n_2$ of the second electrode 500", "the refractive index $n_1$ of the second charge transport layer 400", and "the refractive index $n_0$ of the perovskite absorption layer 300" include: at room temperature, measuring solid film samples using a refractometer (Mettler Toledo R5) to directly obtain the refractive index.

Through in-depth research, the inventors of this application found that when the perovskite solar cell of this application meets the preceding conditions, and optionally meets one or more of the following conditions, the power conversion efficiency of the cell can be further improved.

In some embodiments, electrode materials of the first electrode 100 and the second electrode 500 may include an organic conductive material, an inorganic conductive material, or an organic-inorganic hybrid conductive material. For example, the organic conductive material includes but is not limited to PEDOT (polymer of 3,4-ethylenedioxythiophene), polythiophene, and polyacetylene. The inorganic conductive material includes but is not limited to FTO (fluorine-doped $SnO_2$ conductive glass), ITO (indium tin oxide), AZO (aluminum-doped zinc oxide transparent conductive glass), metal, and carbon derivatives.

In some embodiments, the refractive index $n_2$ of the second electrode 500 ranges from 0.5 to 3, for example, from 0.7 to 2.8, from 1 to 2.5, from 1.2 to 2.2, from 1.5 to 2, and from 1.5 to 1.7.

In some embodiments, the refractive index $n_1$ and thickness d of the second charge transport layer 400 meet the relation $d=k\lambda/2n_1$, where k is an integer, for example, 1, 2, 3, and 4. In some other embodiments, with k=1, the refractive index $n_1$ and thickness d of the second charge transport layer 400 meet the relation $d=\lambda/2n_1$. With the same refractive index and incident light, the thickness of the second charge transport layer 400 is relatively low, and correspondingly, an enhanced reflection effect of the second charge transport layer 400 is also relatively high.

In some embodiments, the refractive index $n_1$ of the second charge transport layer 400 ranges from 0.5 to 3, for example, from 0.7 to 2.8, from 1 to 2.5, from 1.2 to 2.2, from 1.5-2, and from 1.5 to 1.7.

In some embodiments, the refractive index of the second charge transport layer 400 may be adjusted by doping the second charge transport layer 400 with a radioactive material, and by controlling the thickness of the second charge transport layer 400, the refractive index $n_1$ and thickness d of the second charge transport layer 400 meet the relations $d=\lambda/2n_1$ and $n_1^2=an_2\times n_0$. The inventors found that, by doping the second charge transport layer 400 with a radioactive material, not only the refractive index of the second charge transport layer can be adjusted, but also high-energy radiation particles in the radioactive material can self-stimulate to generate carriers because the radioactive material in the second charge transport layer 400 has radioactivity, thereby increasing a quantity of carriers in the perovskite solar cell 1000 and increasing the cell current.

In some embodiments, based on a total mass of the second charge transport layer 400, a percentage of the radioactive material does not exceed 30wt%, for example, ranges from 1wt% to 30wt%, from 2wt% to 29wt%, from 3wt% to 28wt%, from 3wt% to 25wt%, from 3wt% to 22wt%, from 3wt% to 20wt%, from 3wt% to 18wt%, from 3wt% to 15wt%, from 3wt% to 12wt%, and from 3wt% to 10wt%. Specifically, the refractive index of the second charge transport layer 400 can be controlled by adjusting the percentage of the radioactive material in the second charge transport layer 400, so that the refractive index $n_1$ and thickness d of the second charge transport layer 400 meet the relations $d=k\lambda/2n_1$ and $n_1^2=an_2\times n_0$, so as to achieve the enhanced reflection effect of the second charge transport layer 400. If the percentage of the radioactive material is too high, the high-energy particles radiated by the radioactive material will damage the perovskite absorption layer 300. In some other embodiments, based on the total mass of the second charge transport layer 400, the percentage of the radioactive material ranges from 3wt% to 15wt%.

In some embodiments, the radioactive material in the second charge transport layer 400 includes at least one of an $\alpha$-type radiation source material and a $\beta$-type radiation source material. For example, the $\alpha$-type radiation source material includes at least one of $^{210}Po$ and compounds thereof, $^{228}Th$ and compounds thereof, $^{23S}U$ and compounds thereof, $^{238}Pu$ and compounds thereof, $^{241}Am$ and compounds thereof, $^{242}Cm$ and compounds thereof, and $^{244}Cm$ and compounds thereof; and the $\beta$-type radiation source material includes at least one of $(C_4H_3{}^3H_5{}^-)n$, $^3H_2$, $Ti^3H_4$, $^{14}C$ and compounds thereof, $^{35}S$ and compounds thereof, $^{63}Ni$ and compounds thereof, $^{90}Sr$ and compounds thereof, $^{99}Tc$ and compounds thereof, $^{106}Ru$ and compounds thereof, $^{137}Cs$ and compounds thereof, $^{144}Ce$ and compounds thereof, $^{147}Pm$ and compounds thereof, $^{151}Sm$ and compounds thereof, and $^{226}Ra$ and compounds thereof.

The perovskite solar cell 1000 of this application may be a regular perovskite solar cell or an inverted perovskite solar cell.

In some embodiments of this application, the perovskite solar cell 1000 is a regular perovskite solar cell, the second charge transport layer 400 is a hole transport layer, and the first charge transport layer 200 is an electron transport layer, where a hole transport material in the hole transport layer includes 2,2',7,7'-tetra(N,N-para-methoxyaniline)-9,9'-spirobifluorene, methoxytriphenylamine-fluoroformamidine, poly[bis(4-phenyl)(2,4,6-trimethylphenyl)amine], poly(3,4-ethylenedioxythiophene), polystyrene sulfonic acid, poly(3-hexylthiophene), triphenylamine with triptycene as the core, 3,4-ethylenedioxythiophene-methoxytriphenylamine, N-(4-anilino)carbazole-spirobifluorene, polythiophene, phosphate-based monomers, carbazole-based monomers, sulfonic acid-based monomers, triphenylamine-based monomers, aromatic monomers, metal oxides, and cuprous thiocyanate, and a metal element in the metal oxides includes at least one of Ni, Mo, and Cu. An electron transport material in the electron transport layer includes at least one of imide compounds, quinone compounds, fullerenes and derivatives thereof, metal oxides, silicon oxides, strontium titanate, calcium titanate, lithium fluoride, and calcium fluoride, where a metal element in the metal oxides includes at least one of Mg, Cd, Zn, In, Pb, W, Sb, Bi, Hg, Ti, Ag, Mn, Fe, V, Sn, Zr, Sr, Ga, and Cr. Further, the electron transport material in the electron transport layer includes poly(3,4-ethylenedioxythiophene), polystyrene sulfonate, poly[bis(4-phenyl)(2,4,6-trimethylphenyl)amine], NiOx, MoOx, 2,2',7,7'-tetra(N,N-para-methoxyaniline)-9,9'-spirobifluorene, $WO_3$, polyethyleneimine, polyethyleneimine, ZnO, $TiO_2$, [6,6]-phenyl-C61-butyric acid methyl ester, and $SnO_2$.

In some embodiments, the perovskite solar cell 1000 is an inverted perovskite solar cell, the second charge transport layer 400 is an electron transport layer, and the first charge transport layer 400 is a hole transport layer, where an electron transport material in the electron transport layer includes at least one of imide compounds, quinone compounds, fullerenes and derivatives thereof, metal oxides, silicon oxides, strontium titanate, calcium titanate, lithium fluoride, and calcium fluoride, where a metal element in the metal oxides includes at least one of Mg, Cd, Zn, In, Pb, W, Sb, Bi, Hg, Ti, Ag, Mn, Fe, V, Sn, Zr, Sr, Ga, and Cr. Further, the electron transport material in the electron transport layer includes poly(3,4-ethylenedioxythiophene), polystyrene sulfonate, poly[bis(4-phenyl)(2,4,6-trimethylphenyl)amine], NiOx, MoOx, 2,2',7,7'-tetra(N,N-para-methoxyaniline)-9,9'-spirobifluorene, $WO_3$, polyethyleneimine, polyethyleneimine, ZnO, $TiO_2$, [6,6]-phenyl-C61-butyric acid methyl ester, and $SnO_2$. A hole transport material in the hole transport layer includes 2,2',7,7'-tetra(N,N-para-methoxyaniline)-9,9'-spirobifluorene, methoxytriphenylamine-fluoroformamidine, poly[bis(4-phenyl)(2,4,6-trimethylphenyl)amine], poly(3,4-ethylenedioxythiophene), polystyrene sulfonic acid, poly(3-hexylthiophene), triphenylamine with triptycene as the core, 3,4-ethylenedioxythiophene-methoxytriphenylamine, N-(4-anilino)carbazole-spirobifluorene, polythiophene, phosphate-based monomers, carbazole-based monomers, sulfonic acid-based monomers, triphenylamine-based monomers, aromatic monomers, metal oxides, and cuprous thiocyanate, and a metal element in the metal oxides includes at least one of Ni, Mo, and Cu.

In some embodiments, the refractive index $n_2$ of the perovskite absorption layer 300 ranges from 0.5 to 3, for example, from 0.7 to 2.8, from 1 to 2.5, from 1.2 to 2.2, from 1.5 to 2, and from 1.5 to 1.7.

In some embodiments, a perovskite material in the perovskite absorption layer 300 has a chemical formula of $ABX_3$, where A is an inorganic or organic or organic-inorganic hybrid cation, B is a metal cation, and X is an inorganic or organic or organic-inorganic hybrid anion, for example, A is an organic amine cation, B is a divalent metal cation, and X is a halogen anion or SCN-. In some examples, A in $ABX_3$ may include at least one of $CH_3NH_3^+$ and $HC(NH_2)_2^+$; in other words, A may be $CH_3NH_3^+$, $HC(NH_2)_2^+$, or a mixture of the two in any ratio. It should be understood that A may further include a metal ion, for example, at least one of $Cs^+$, $Rb^+$, and $K^+$. B in $ABX_3$ may be at least one of $Pb^{2+}$, $Sn^{2+}$, and $Ge^{2+}$. For example, $ABX_3$ may be $CH_3NH_3PbI_3$, $CH_3NH_3SnI_3$, $CH_3NH_3PbI_2Cl$, $CH_3NH_3PbI_2Br$, and $CH_3NH_3Pb(I_{1-x}Br_x)_3$ (where $0<x<1$).

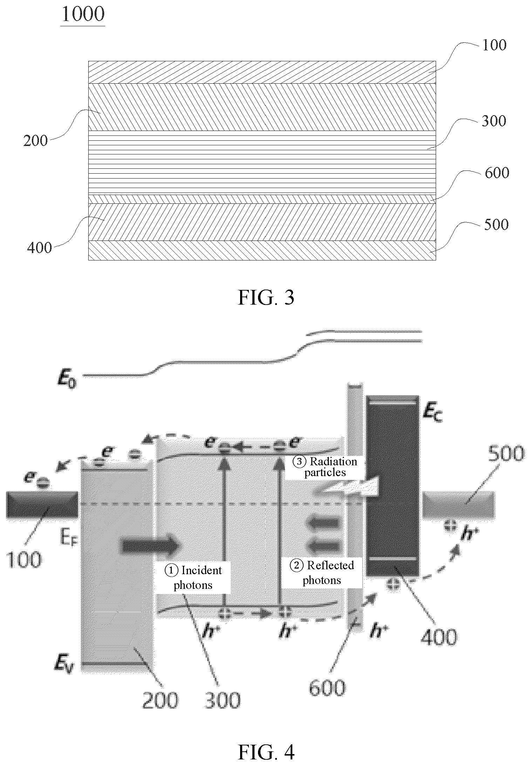

In some embodiments, the high-energy radiation particles in the radioactive material in the second charge transport layer 400 may damage the perovskite absorption layer 300. Therefore, to reduce the damage to the perovskite absorption layer 300, referring to FIG. 3, a buffer layer 600 is arranged between the second charge transport layer 400 and the perovskite absorption layer 300, where a valence band maximum and a conduction band minimum of a material of the buffer layer 600 are at least 2.5 eV apart. In this way, the buffer layer 600 meeting this condition can absorb the high-energy particles radiated by the radioactive material, undergo energy deposition, convert the kinetic energy of the high-energy particles into energy of charge, thereby effectively reducing the damage to the perovskite absorption layer 300.

According to some examples, a method for testing energy band information (valence band maximum, conduction band minimum, or the like) of the material of the buffer layer 600 includes: at room temperature and normal pressure, obtaining an energy band distribution of the material using an X-ray photoelectron spectrometer (XPS) model Escalab 250Xi (from Thermo Scientific), and obtaining a valence band maximum position and a conduction band minimum position from an XPS spectrum.

In some embodiments, a material of the buffer layer 600 includes at least one of an inorganic wide bandgap semiconductor material and an organic wide bandgap semiconductor material, where the inorganic wide bandgap semiconductor material includes at least one of an II-VI group compound semiconductor, an III-V group compound semiconductor, transition metal oxides, transition metal halides, and a silicon-based wide bandgap semiconductor. Specifically, the II-VI group compound semiconductor refers to a compound semiconductor composed of group IIB elements (Zn, Cd, Hg) and group VIA elements (S, Se, Te, O) in the periodic table, for example, ZnS, ZnSe, ZnTe, CdS, CdSe, CdTe, HgS, HgSe, and HgTe. The III-V group compound semiconductor refers to a compound semiconductor composed of group IIIA elements (B, Al, Ga, In) and group VA elements (N, P, As, Sb) in the periodic table, for example, BN, BP, BAs, BSb, AlN, AlP, AlAs, AlSb, GaN, GaP, GaAs, GaSb, InAs, InN, InP, and InSb. The transition metal oxides include but are not limited to chromium oxide, manganese oxide, iron oxide, cobalt oxide, nickel oxide, copper oxide, zinc oxide, palladium oxide, silver oxide, platinum oxide. The transition metal halides include but are not limited to chromium chloride, manganese chloride, iron chloride, cobalt chloride, nickel chloride, copper chloride, zinc chloride, palladium chloride, silver chloride, platinum chloride, chromium bromide, manganese bromide, iron bromide, cobalt bromide, nickel bromide, copper bromide, zinc bromide, palladium bromide, silver bromide, platinum bromide. The silicon-based wide bandgap semiconductor includes.... The organic wide bandgap semiconductor material includes at least one of C60, PC61BM ((6,6)-phenyl-C61-butyric acid methyl ester), PC71BM ((6,6)-phenyl-C71-butyric acid methyl ester), P3HT (poly(3-hexylthiophene)), PTAA (poly[bis(4-phenyl)(2,4,6-trimethylphenyl)amine]), and PEDOT:PSS (poly(3,4-ethylenedioxythiophene)-poly(styrenesulfonate)).

In some embodiments, a thickness of the buffer layer 600 does not exceed 10 nm, for example, ranges from 2 nm to 10 nm, from 2 nm to 8 nm, from 2 nm to 6 nm, from 2 nm to 4 nm, or from 2 nm to 3 nm. In this way, incident light reflection can be reduced and the power conversion efficiency of the cell can be improved.

In some embodiments, a refractive index $n_3$ of the buffer layer 600, the refractive index $n_1$ of the second charge transport layer 400, and the refractive index $n_2$ of the second electrode 100 meet the following relation: $n_1^2=bn_2\times n_3$, where b is a correction factor with a value of 0.5 to 1.5, for example, 0.5, 0.6, 0.7, 0.8, 0.9, 1.0, 1.1, 1.2, 1.3, 1.4, and 1.5. The refractive index $n_0$ of the buffer layer 600 ranges from 0.5 to 3, for example, from 0.7 to 2.8, from 1 to 2.5, from 1.2 to 2.2, from 1.5 to 2, and from 1.5 to 1.7; and the refractive index $n_2$ of the second electrode 100 ranges from 0.5 to 3, for example, from 0.7 to 2.8, from 1 to 2.5, from 1.2 to 2.2, from 1.5 to 2, and from 1.5 to 1.7. The inventors found that when the refractive

index $n_3$ of the buffer layer 600, the refractive index $n_1$ of the second charge transport layer 400, and the refractive index $n_2$ of the second electrode 500 meet the foregoing relation, a system composed of the second electrode 500, the second charge transport layer 400, and the buffer layer 600 can improve the reflectivity of the second charge transport layer 400, so that part of the light passing through the perovskite absorption layer 300 can be reflected back to the perovskite absorption layer 300 through the second charge transport layer 400, increasing a quantity of photogenerated carriers in the perovskite absorption layer 300 and increasing the cell current.

According to some examples, a method for testing the refractive index $n_3$ of the buffer layer 600 includes: at room temperature, measuring solid film samples using a refractometer (Mettler Toledo R5) to directly obtain the refractive index.

Specifically, referring to FIG. 4, the perovskite solar cell 1000 includes a first electrode 100, a first charge transport layer 200, a buffer layer 600, a perovskite absorption layer 300, a second charge transport layer 400, and a second electrode 500. The second charge transport layer 400 being a hole transport layer and the first charge transport layer 200 being an electron transport layer are used as an example, and the perovskite absorption layer 300, the second charge transport layer 400, the second electrode 500, and the buffer layer 600 meet all the relations: $d=k\lambda/2n_1$, $n_1^2=an_2 \times n_0$, and $n_1^2=bn_2 \times n_3$. The incident light enters from the side of the first electrode 100, passes through the first charge transport layer 200, and enters the perovskite absorption layer 300; the perovskite material in the perovskite absorption layer 300 absorbs the incident photons to generate electron-hole pairs; and the electron-hole pairs dissociate to form free carriers, where the free electrons are transmitted to the first positive electrode 100 through the first charge transport layer 200, and the free electron holes are transmitted to the second electrode 500 through the second charge transport layer 400. Due to the excellent enhanced reflection effect of the second charge transport layer 400, part of the light passing through the perovskite absorption layer 300 is reflected back to the perovskite absorption layer 300 by the second charge transport layer 400, increasing a quantity of carriers in the perovskite absorption layer 300 and increasing the cell current. In addition, the radioactive material in the second charge transport layer 400 has radioactivity, and its high-energy radiation particles can self-stimulate to generate carriers, increasing a quantity of carriers, thereby further increasing the cell current. The buffer layer 600 arranged between the second charge transport layer 400 and the perovskite absorption layer 300 can reduce the damage of high-energy radiation particles from the radioactive material in the second charge transport layer 400 to the perovskite absorption layer 300.

A second aspect of this application provides a preparation method of perovskite solar cell, including:

S1: Form a first charge transport layer on a side of a first electrode.
S2: Form a perovskite absorption layer on a side of the first charge transport layer away from the first electrode.
S3: Form a second charge transport layer on a side of the perovskite absorption layer away from the charge transport layer.
S4: Form a second electrode on a side of the second charge transport layer away from the perovskite absorption layer;

In the perovskite solar cell of this application, the perovskite absorption layer, the second charge transport layer, and the second electrode meet both of the following relations: $d=k\lambda/2n_1$ and $n_1^2=an_2 \times n_0$, so that the second charge transport layer in the perovskite cell has excellent enhanced reflection effect, and thus part of light passing through the perovskite absorption layer can be reflected back to the perovskite absorption layer through the second charge transport layer, increasing a quantity of carriers in the perovskite absorption layer, and increasing a cell current. In this way, the perovskite solar cell obtained using the method of this application has relatively high power conversion efficiency.

In some embodiments, the forming a first charge transport layer in Step S1, the forming a perovskite absorption layer in Step S2, the forming a second charge transport layer in Step S2, and the forming a second electrode in Step S4 may use chemical bath deposition, electrochemical deposition, chemical vapor deposition, physical epitaxial growth, thermal evaporation co-evaporation, atomic layer deposition, magnetron sputtering, precursor liquid spin coating, precursor liquid slit coating, precursor liquid blade coating, mechanical pressing, and the like, where thermal evaporation co-evaporation and precursor liquid coating (spin coating) are preferred.

In some embodiments, the refractive index $n_1$ of the second charge transport layer may be adjusted by doping the second charge transport layer with a radioactive material, and by controlling the thickness of the second charge transport layer, the refractive index $n_1$ and thickness d of the second charge transport layer meet the relations $d=k\lambda/2n_1$ and $n_1^2=an_2 \times n_0$. The inventors found that by doping the second charge transport layer with a radioactive material, not only the refractive index of the second charge transport layer can be adjusted, but also high-energy radiation particles in the radioactive material can self-stimulate to generate carriers because the radioactive material in the second charge transport layer has radioactivity, thereby increasing a quantity of carriers in the perovskite solar cell and increasing the cell current.

In an example, co-evaporation or magnetron sputtering can be used to form the second charge transport layer including radioactive materials and charge transport layer materials on a side of the perovskite absorption layer.

In this way, using the method of this application, the above-described perovskite solar cell with excellent power conversion efficiency can be prepared.

In some embodiments of this application, the high-energy radiation particles in the radioactive material in the second charge transport layer may damage the perovskite absorption layer. Therefore, to reduce the damage to the perovskite absorption layer, a buffer layer is formed between the second charge transport layer and the perovskite absorption layer, where a valence band maximum and a conduction band minimum of a material of the buffer layer are at least 2.5 eV apart. In this way, the buffer layer meeting this condition can absorb the high-energy particles radiated by the radioactive material, undergo energy deposition, and convert the kinetic energy of the high-energy particles into energy of charge, thereby effectively reducing the damage to the perovskite absorption layer.

In an example, a method of forming a buffer layer between the second charge transport layer and the perovskite absorption layer may use an evaporation method.

It should be noted that the first electrode, radioactive material, charge transport material, buffer layer, and second electrode used in the preparation method of perovskite solar cell are the same as described above and will not be repeated herein.

A third aspect of this application provides an electrical apparatus, including the perovskite solar cell according to the first aspect or a perovskite solar cell prepared by the method according to the second aspect, where the perovskite solar cell is configured to provide electrical energy. In an example, the electrical apparatus may be a lighting element, a display element, a vehicle, or the like.

To describe the technical problems solved by the embodiments of this application, technical solutions, and beneficial effects more clearly, the following further provides descriptions in detail with reference to the embodiments and accompanying drawings. Apparently, the described embodiments are only some but not all of the embodiments of this application. The following description of at least one exemplary embodiment is merely illustrative and definitely is not construed as any limitation on this application or on use of this application. All other embodiments obtained by persons of ordinary skill in the art based on the embodiments of this application without creative efforts shall fall within the protection scope of this application.

**Example 1**

The preparation method of perovskite solar cell included the following steps:

(1) The surface of FTO conductive glass with a dimension of 2.0 cm×2.0 cm was cleaned with acetone and isopropanol twice in sequence; and next the FTO conductive glass was immersed in deionized water, ultrasonicated for 10 minutes, then dried in a blowing drying oven, and placed in a glove box ($N_2$ atmosphere), served as a first electrode.

(2) Preparing an electron transport layer: A concentration of 3wt% $SnO_2$ nanocolloidal aqueous solution was spin applied on the first electrode at a speed of 4000 rpm to 6500 rpm, and then the resulting coated electrode was transferred to a constant temperature hot plate, heated at 150°C for 15 minutes, and cooled to room temperature to form an electron transport layer on the first electrode with a thickness of 30 nm.

(3) Preparing a perovskite absorption layer: A concentration of 1.5 mol/L $FAPbI_3$ DMF solution was spin applied on the electron transport layer obtained in Step 2 at a speed of 3000 rpm to 4500 rpm, and then the coated electrode was transferred to a constant temperature hot plate, heated at 100°C for 30 minutes, and cooled to room temperature to form a perovskite absorption layer on the electron transport layer, with a thickness of 500 nm. The perovskite absorption layer with $n_0$ of 2.59 absorbed the main band $\lambda$ of light absorbed with a wavelength of 700 nm.

(4) Preparing a hole transport layer: A chlorobenzene solution of Spiro-OMeTAD (2,2',7,7'-tetra(N,N-para-methoxyaniline)-9,9'-spirobifluorene) with a concentration of 73 mg/mL was spin applied on the perovskite absorption layer at a speed of 3000 rpm, with a spin coating time of 20 seconds, to obtain a hole transport layer with a thickness of 180.4 nm and a refractive index $n_1$ of 1.94.

(5) Preparing a second electrode: The sample obtained in Step (5) was placed into a vacuum coating machine, and Ag electrode evaporation was performed on the surface of the hole transport layer obtained under a vacuum condition of $5×10^{-4}$ Pa, at an evaporation rate of 0.1 Å/s. The Ag electrode had a thickness of 80 nm and served as the second electrode with a refractive index $n_2$ of 1.48.

The preparation methods of perovskite solar cell in Example 2 and Example 3 are the same as that in Example 1, with differences as shown in Table 1.

**Table 1**

| | Perovskite absorption layer | | | Hole transport layer | | | Second electrode | |
|---|---|---|---|---|---|---|---|---|
| | Composition | Thickness (nm) | Refractive index $n_0$ | Composition | Refractive index $n_1$ | Thickness (nm) | Composition | Refractive index $n_2$ |
| Example 1 | FAPbI$_3$ | 500 | 2.59 | Spiro-OMeTAD | 1.94 | 180.4 | Ag | 1.48 |
| Example 2 | FAPbI$_3$ | 500 | 2.59 | P3HT | 2.08 | 168.3 | Ag | 1.48 |
| Example 3 | FAPbI$_3$ | 500 | 2.59 | MoO$_3$ | 2.1 | 166.7 | Ag | 1.48 |

Example 4

The preparation method of perovskite solar cell included the following steps:

(1) The surface of FTO conductive glass with a dimension of 2.0 cm×2.0 cm was cleaned with acetone and isopropanol twice in sequence; and next the FTO conductive glass was immersed in deionized water, ultrasonicated for 10 minutes, then dried in a blowing drying oven, and placed in a glove box (N$_2$ atmosphere), served as a first electrode.

(2) Preparing an electron transport layer: A concentration of 3wt% SnO$_2$ nanocolloidal aqueous solution was spin applied on the first electrode at a speed of 4000 rpm to 6500 rpm, and then the resulting coated electrode was transferred to a constant temperature hot plate, heated at 150°C for 15 minutes, and cooled to room temperature to form an electron transport layer on the first electrode with a thickness of 30 nm.

(3) Preparing a perovskite absorption layer: A concentration of 1.5 mol/L FAPbI$_3$ DMF solution was spin applied on the electron transport layer obtained in Step 2 at a speed of 3000 rpm to 4500 rpm, and then the coated electrode was transferred to a constant temperature hot plate, heated at 100°C for 30 minutes, and cooled to room temperature to form a perovskite absorption layer on the electron transport layer, with a thickness of 500 nm. The perovskite absorption layer with $n_0$ of 2.59 absorbed the main band $\lambda$ of light absorbed with a wavelength of 700 nm.

(4) Preparing a buffer layer: The sample obtained in Step 3 was placed into a vacuum coating machine, and CuI evaporation was performed on the surface of the perovskite absorption layer obtained under a vacuum condition of 5×10$^{-4}$ Pa, with a thickness of 3 nm and a refractive index $n_0$ of 2.63.

(5) Preparing a hole transport layer: The sample obtained in Step (4) was placed into a vacuum coating machine, and $^{63}$NiCl$_x$ (x≥2) and CuO co-evaporation were performed on the surface of the buffer layer obtained under a vacuum condition of 5×10$^{-4}$ Pa, to form an electron transport layer, where $^{63}$NiCl$_x$ accounted for 5wt% of the electron transport layer, the thickness of the hole transport layer was d=176.8 nm, and the refractive index $n_1$ was 1.98 (d=k$\lambda$/2n$_1$, k=1).

(6) Preparing a second electrode: The sample obtained in Step (5) was placed into a vacuum coating machine, and Ag electrode evaporation was performed on the surface of the hole transport layer obtained under a vacuum condition of 5×10$^{-4}$ Pa, at an evaporation rate of 0.1 Å/s. The Ag electrode had a thickness of 80 nm and served as the second electrode with a refractive index $n_2$ of 1.48.

The preparation methods of perovskite solar cell in Examples 4 to 21 were the same as that in Example 1, with differences as shown in Table 2.

In the comparative example, the preparation methods of the first electrode, electron transport layer, perovskite absorption layer, and second electrode of the perovskite solar cell were the same as those in Example 1, except that there was no hole transport layer and buffer layer, and the step of preparing the hole transport layer included: A chlorobenzene solution of Spiro-OMeTAD (2,2',7,7'-tetra(N,N-para-methoxyaniline)-9,9'-spirobifluorene) with a concentration of 73 mg/mL was spin applied on the perovskite absorption layer at a speed of 3000 rpm, with a spin coating time of 20 seconds, to obtain a hole transport layer with a thickness of 150 nm.

**Table 2**

| | Buffer layer | | | Hole transport layer | | | | Second electrode | | Perovskite absorption layer |
|---|---|---|---|---|---|---|---|---|---|---|
| | Composition | Thickness (nm) | Refractive index $n_3$ | Composition of radioactive material | Percentage of radioactive material (wt%) | Refractive index $n_1$ | Thickness (nm) | Composition | Refractive index $n_2$ | Refractive index $n_0$ |
| Example 4 | CuI | 3 | 2.63 | $^{63}NiCl_x$ | 5 | 1.98 | 176.8 | Ag | 1.48 | 2.59 |
| Example 5 | CuI | 3 | 2.63 | $^{63}NiCl_x$ | 10 | 2.05 | 170.7 | Ag | 1.48 | 2.59 |
| Example 6 | CuI | 3 | 2.63 | $^{63}NiCl_x$ | 3 | 1.96 | 178.6 | Ag | 1.48 | 2.59 |
| Example 7 | CuI | 3 | 2.63 | $^{63}NiCl_x$ | 15 | 2.10 | 166.7 | Ag | 1.48 | 2.59 |
| Example 8 | CuI | 3 | 2.63 | $^{63}NiCl_x$ | 20 | 2.14 | 163.6 | Ag | 1.48 | 2.59 |
| Example 9 | CuI | 3 | 2.63 | $^{63}NiCl_x$ | 30 | 2.23 | 157.0 | Ag | 1.48 | 2.59 |
| Example 10 | CuI | 3 | 2.63 | $^{35}S$ | 10 | 2.08 | 168.3 | Ag | 1.48 | 2.59 |
| Example 11 | CuI | 3 | 2.63 | $^{14}C$ | 10 | 2.06 | 169.9 | Ag | 1.48 | 2.59 |
| Example 12 | CuI | 3 | 2.63 | $Ti_3H_4$ | 10 | 2.09 | 167.5 | Ag | 1.48 | 2.59 |
| Example 13 | PC61BM | 3 | 2.30 | $^{63}NiCl_x$ | 10 | 2.05 | 170.7 | Ag | 1.48 | 2.59 |
| Example 14 | PEDOT:PSS | 3 | 3.2 | $^{63}NiCl_x$ | 10 | 2.05 | 170.7 | Ag | 1.48 | 2.59 |
| Example 15 | ZnS | 3 | 2.35 | $^{63}NiCl_x$ | 10 | 2.05 | 170.7 | Ag | 1.48 | 2.59 |
| Example 16 | CdSe | 3 | 2.56 | $^{63}NiCl_x$ | 10 | 2.05 | 170.7 | Ag | 1.48 | 2.59 |
| Example 17 | BN | 3 | 2.11 | $^{63}NiCl_x$ | 10 | 2.05 | 170.7 | Ag | 1.48 | 2.59 |
| Example 18 | CuI | 10 | 2.14 | $^{63}NiCl_x$ | 10 | 2.05 | 170.7 | Ag | 1.48 | 2.59 |
| Example 19 | CuI | 8 | 2.14 | $^{63}NiCl_x$ | 10 | 2.05 | 170.7 | Ag | 1.48 | 2.59 |
| Example 20 | CuI | 6 | 2.14 | $^{63}NiCl_x$ | 10 | 2.05 | 170.7 | Ag | 1.48 | 2.59 |
| Example 21 | / | / | / | $^{63}NiCl_x$ | 10 | 2.05 | 170.7 | Ag | 1.48 | 2.59 |
| Comparative Example | / | / | / | / | / | 1.94 | 150 | Ag | 1.48 | 2.59 |

Performance tests were conducted on the perovskite solar cells of Examples 1 to 21 and Comparative Example.

Power conversion efficiency test: In the atmospheric environment, with an AM1.5G standard light source used as solar simulation light source, a current-voltage characteristic curve of the cell was measured using a four-channel digital source meter (Keithley 2440) under the irradiation of the light source, to obtain the open-circuit voltage Voc, short-circuit current density Jsc, and fill factor FF (Fill Factor) of the cell, and then the power conversion efficiency Eff (Efficiency) of the cell was calculated.

The power conversion efficiency was calculated as follows:

$$Eff = Pout/Popt = Voc \times Jsc \times (Vmpp \times Jmpp)/(Voc \times Jsc) = Voc \times Jsc \times FF,$$

where Pout, Popt, Vmpp, and Jmpp were cell operating output power, incident light power, cell voltage at maximum power point, and current at maximum power point, respectively.

Damage to the perovskite absorption layer was characterized by tracking and evaluating the long-term (100 hours) PCE (power conversion efficiency) decay of the cell device. Specifically, the cell was stored in an atmospheric environment without encapsulation, and the PCE changes of the cell were recorded from 0 to 100 hours, with a collection interval of 10 hours. The degree of reduction in PCE after 100 hours compared to the initial PCE was calculated as the damage to the perovskite absorption layer = (initial PCE - PCE at 100-th hour) / initial PCE.

The power conversion efficiency and damage to the perovskite absorption layer of the perovskite solar cells in Examples 1 to 21 and Comparative Example were characterized as shown in Table 3.

**Table 2**

|  | Power conversion efficiency (%) | Damage to perovskite absorption layer and loss of efficiency after 100 hours (%) |
|---|---|---|
| Example 1 | 19.9 | 4.7 |
| Example 2 | 19.7 | 4.9 |
| Example 3 | 19.6 | 5.0 |
| Example 4 | 21.8 | 3.6 |
| Example 5 | 21.5 | 3.7 |
| Example 6 | 21.3 | 3.6 |
| Example 7 | 21.1 | 3.8 |
| Example 8 | 20.7 | 3.8 |
| Example 9 | 20.4 | 4.0 |
| Example 10 | 21.0 | 3.7 |
| Example 11 | 21.2 | 3.8 |
| Example 12 | 20.8 | 3.7 |
| Example 13 | 20.4 | 4.4 |
| Example 14 | 20.3 | 4.5 |
| Example 15 | 20.8 | 3.7 |
| Example 16 | 20.7 | 3.7 |
| Example 17 | 21.1 | 3.5 |
| Example 18 | 20.6 | 3.0 |
| Example 19 | 20.9 | 3.3 |
| Example 20 | 21.2 | 3.4 |
| Example 21 | 21.4 | 6.0 |
| Comparative Example | 19.5 | 5.2 |

As shown in Table 3, the power conversion efficiency of the perovskite solar cells in Examples 1 to 21 is significantly higher than that of Comparative Example, indicating that when the perovskite absorption layer, the second charge transport layer, and the second electrode meet both of the relations $d=k\lambda/2n_1$ and $n_1^2=an_2\times n_0$, the enhanced reflection effect of the second charge transport layer in the perovskite cell of the perovskite solar cell can be improved, so that part of the light passing through the perovskite absorption layer can be reflected back to the perovskite absorption layer through the second charge transport layer, increasing a quantity of carriers in the perovskite absorption layer, increasing the cell current, and improving the power conversion efficiency of the cell. In addition, the power conversion efficiency of the perovskite solar cells in Examples 4 to 21 is higher than that of Examples 1 to 3, indicating that by doping the second charge transport layer with a radioactive material and making the buffer layer meet the relation $n_1^2=bn_3\times n_0$, the power conversion efficiency of the perovskite solar cell can be further improved. Furthermore, the damage to the perovskite absorption layer in the perovskite solar cells of Examples 4 to 20 is lower than that in Example 21, indicating that by arranging a buffer layer between the second charge transport layer and the perovskite absorption layer, the damage to the perovskite absorption layer caused by the radioactive material in the second charge transport layer can be reduced.

In conclusion, it should be noted that the foregoing embodiments are for description of the technical solutions of this application only rather than for limiting this application. Although this application has been described in detail with reference to the foregoing embodiments, persons of ordinary skill in the art should appreciate that they can still make modifications to the technical solutions described in the embodiments or make equivalent replacements to some or all technical features thereof. All such modifications and equivalent replacements do not make the essence of the corresponding technical solutions deviate from the scope of the technical solutions of the embodiments of this application, and shall fall within the scope of claims and specification of this application. In particular, as long as there is no structural conflict, the various technical features mentioned in the embodiments can be combined in any manner. This application is not limited to the specific embodiments disclosed in this specification but includes all technical solutions falling within the scope of the claims.

**Claims**

1. A perovskite solar cell, comprising:

   a first electrode;
   a first charge transport layer, wherein the first charge transport layer is arranged on a side of the first electrode;
   a perovskite absorption layer, wherein the perovskite absorption layer is arranged on a side of the first charge transport layer away from the first electrode;
   a second charge transport layer, wherein the second charge transport layer is arranged on a side of the perovskite absorption layer away from the first charge transport layer; and
   a second electrode, wherein the second electrode is arranged on a side of the second charge transport layer away from the perovskite absorption layer;
   wherein the perovskite absorption layer, the second charge transport layer, and the second electrode meet the following relations:

   $d=k\lambda/2n_1$ and $n_1^2=an_2\times n_0$,
   wherein d represents a thickness of the second charge transport layer in nm;
   k is a positive integer;
   $\lambda$ represents a wavelength of a main band of light absorbed by the perovskite absorption layer in nm;
   $n_0$ is a refractive index of the perovskite absorption layer;
   $n_1$ is a refractive index of the second charge transport layer;
   $n_2$ is a refractive index of the second electrode; and
   a is a correction factor with a value of 0.5 to 1.5.

2. The perovskite solar cell according to claim 1, wherein the refractive index $n_0$ of the perovskite absorption layer ranges from 0.5 to 3.

3. The perovskite solar cell according to claim 1 or 2, wherein the refractive index $n_1$ of the second charge transport layer ranges from 0.5 to 3.

4. The perovskite solar cell according to any one of claims 1 to 3, wherein the refractive index $n_2$ of the second electrode ranges from 0.5 to 3.

5. The perovskite solar cell according to any one of claims 1 to 4, wherein the second charge transport layer comprises a radioactive material.

6. The perovskite solar cell according to any one of claims 1 to 5, wherein based on a total mass of the second charge transport layer, a percentage of the radioactive material in the second charge transport layer does not exceed 30wt%, and optionally ranges from 3wt% to 15wt%.

7. The perovskite solar cell according to any one of claims 1 to 6, further comprising a buffer layer, wherein the buffer layer is arranged between the second charge transport layer and the perovskite absorption layer.

8. The perovskite solar cell according to any one of claims 1 to 7, wherein a valence band maximum and a conduction band minimum of a material of the buffer layer is at least 2.5 eV apart.

9. The perovskite solar cell according to any one of claims 1 to 8, wherein a refractive index $n_3$ of the buffer layer, the refractive index $n_1$ of the second charge transport layer, and the refractive index $n_2$ of the second electrode meet the following relation: $n_1^2 = bn_2 \times n_3$, wherein b is a correction factor with a value of 0.5 to 1.5.

10. The perovskite solar cell according to any one of claims 1 to 9, wherein the refractive index $n_3$ of the buffer layer ranges from 0.5 to 3.

11. The perovskite solar cell according to any one of claims 1 to 10, wherein the thickness of the buffer layer does not exceed 10 nm.

12. A method for preparing a perovskite solar cell, comprising:

forming a charge transport layer on a side of a first electrode;
forming a perovskite absorption layer on a side of the charge transport layer away from the first electrode;
forming a second charge transport layer on a side of the perovskite absorption layer away from the charge transport layer; and
forming a second electrode on a side of the second charge transport layer away from the perovskite absorption layer;
wherein the perovskite absorption layer, the second charge transport layer, and the second electrode meet the following relations:

$d = k\lambda/2n_1$  $n_1^2 = an_2 \times n_0$,
wherein d represents a thickness of the second charge transport layer in nm;
k is a positive integer;
$\lambda$ represents a wavelength of a main band of light absorbed by the perovskite absorption layer in nm;
$n_0$ is a refractive index of the perovskite absorption layer;
$n_1$ is a refractive index of the second charge transport layer;
$n_2$ is a refractive index of the second electrode; and
a is a correction factor with a value of 0.5 to 1.5.

13. The method according to claim 12, further comprising: forming a buffer layer between the second charge transport layer and the perovskite absorption layer.

14. An electrical apparatus, comprising the perovskite solar cell according to any one of claims 1 to 11 or a perovskite solar cell prepared by the method according to claim 12 or 13, wherein the perovskite solar cell is configured to provide electrical energy.

Incident light

Upper electrode

Charge transport layer

Perovskite layer

Transmission-light loss

Charge transport layer

Lower electrode

FIG. 1

<u>1000</u>

100

200

300

400

500

FIG. 2

FIG. 3

FIG. 4

## INTERNATIONAL SEARCH REPORT

| International application No. |
|---|
| **PCT/CN2023/070213** |

### A. CLASSIFICATION OF SUBJECT MATTER

H10K30/10(2023.01)i

According to International Patent Classification (IPC) or to both national classification and IPC

### B. FIELDS SEARCHED

Minimum documentation searched (classification system followed by classification symbols)

IPC:H01L H10K

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 太阳能, 光伏, 钙钛矿, 吸收层, 电荷传输, 电子传输, 空穴传输, 波长, 折射率, 反射, photovoltaic, solar cell, perovskite, absorb, electron, hole, transfer, wavelength, refractive index, reflect

### C. DOCUMENTS CONSIDERED TO BE RELEVANT

| Category* | Citation of document, with indication, where appropriate, of the relevant passages | Relevant to claim No. |
|---|---|---|
| Y | US 2016268530 A1 (KABUSHIKI KAISHA TOSHIBA) 15 September 2016 (2016-09-15) description, paragraphs [0003]-[0055], and figure 1 | 1-14 |
| Y | 唐炳华 等 (TANG, Binghua et al.). "平行膜干涉 (Non-official translation: Parallel Membrane Interference)" 物理学 (Physics), 30 September 1995 (1995-09-30), pages 212-213 | 1-14 |
| Y | 许鑫 (XU, Xin). "单层增透膜 (Non-official translation: Single Layer Antireflection Film)" 制版光学 (Non-official translation: Optical Lithography ), 30 June 1987 (1987-06-30), pages 288-289 | 1-14 |
| A | CN 105470338 A (NO.18 RESEARCH INSTITUTE OF CETC) 06 April 2016 (2016-04-06) entire document | 1-14 |
| A | US 2012167965 A1 (AU OPTRONICS CORP.) 05 July 2012 (2012-07-05) entire document | 1-14 |

☐ Further documents are listed in the continuation of Box C.   ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **08 June 2023** | **23 June 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/070213**

| Patent document cited in search report | | | Publication date (day/month/year) | Patent family member(s) | | | Publication date (day/month/year) |
|---|---|---|---|---|---|---|---|
| US | 2016268530 | A1 | 15 September 2016 | JP | 2016167555 | A | 15 September 2016 |
| | | | | JP | 6027641 | B2 | 16 November 2016 |
| CN | 105470338 | A | 06 April 2016 | CN | 105470338 | B | 08 March 2017 |
| US | 2012167965 | A1 | 05 July 2012 | US | 8809673 | B2 | 19 August 2014 |
| | | | | CN | 102280587 | A | 14 December 2011 |
| | | | | CN | 102280587 | B | 10 April 2013 |

Form PCT/ISA/210 (patent family annex) (July 2022)